# EUROPEAN PATENT SPECIFICATION

(11) **EP 0 653 626 B1**
(45) Date of publication and mention of the grant of the patent: **28.05.2003**
(21) Application number: 94308385.7
(22) Date of filing: 14.11.1994
(51) Int. Cl.: G01N 21/88, G01R 31/311, H01L 21/66, H04N 3/15

(54) **Semiconductor device inspection system**
Halbleiterinspektionssystem
Système de contrôle pour un dispostif semi-conducteur

(30) Priority: 16.11.1993 JP 28682093; 07.11.1994 JP 27251994
(43) Date of publication of application: 17.05.1995
(73) Proprietor: HAMAMATSU PHOTONICS K.K., Shizuoka-ken (JP)
(72) Inventor: Oguri, Shigehisa, Hamamatsu-shi, Shizuoka-ken (JP); Inuzuka, Eiji, Hamamatsu-shi, Shizuoka-ken (JP); Suzuki, Kouji, Hamamatsu-shi, Shizuoka-ken (JP); Nagata, Wataru, Hamamatsu-shi, Shizuoka-ken (JP); Hiruma, Yasushi, Hamamatsu-shi, Shizuoka-ken (JP)
(74) Representative: Burke, Steven David

(56) References cited:
- EP-A- 0 149 849
- EP-A- 0 179 309
- EP-A- 0 242 045
- EP-A- 0 418 918
- EP-A- 0 635 883
- US-A- 4 644 404
- US-A- 5 126 569
- PATENT ABSTRACTS OF JAPAN vol. 11 no. 117 (E-498) ,11 April 1987 & JP-A-61 263235 (HITACHI) 21 November 1986,
- PATENT ABSTRACTS OF JAPAN vol. 12 no. 394 (P-773) ,20 October 1988 & JP-A-63 134943 (NEC) 7 June 1988,
- PATENT ABSTRACTS OF JAPAN vol. 13 no. 350 (E-800) ,7 August 1989 & JP-A-01 109735 (FUJITSU) 26 April 1989,
- PATENT ABSTRACTS OF JAPAN vol. 12 no. 130 (E-603) ,21 April 1988 & JP-A-62 257739 (TOSHIBA) 10 November 1987,

## Description

The present invention relates to an inspection system for semiconductor devices. Such an inspection system is used for analyzing anomalous occurrences inside a semiconductor device and for evaluating reliability of a semiconductor device. Such an inspection system is also used for transparently taking an image of inside of a semiconductor device.

As a semiconductor device is highly integrated, e.g., VLSI, difficulty of anomaly analysis and reliability evaluation of internal circuits of the semiconductor device is increased.

In such present condition, much attention is focused on the analysis technology to track down the location of an anomalous portion by detecting very weak light emitted from the anomalous portion in semiconductor device. An emission microscope is known as a semiconductor device inspection apparatus utilizing such analysis technology.

The emission microscope picks up with high sensitivity very weak light caused by hot carriers, which are produced when an electric field is concentrated on an anomalous portion in semiconductor device, or very weak light in the infrared region caused by latchup. Therefore, the emission microscope can measure a semiconductor device to be checked without contact and with high accuracy.

However, the emission microscope has such a problem that since it detects emitted light in the visible to infrared region, it could become incapable of measuring emitted light if there would exist some shielding object between an anomalous portion emitting very weak light and the emission microscope.

In particular, in order to make a semiconductor device being highly integrated, semiconductor devices tend to employ the chip structure in which interconnection between numerous elements such as transistors is made by multilayer wiring located on the top surface. The multilayer wiring interrupts the very weak light caused by an anomaly of an element underneath the multilayer wiring, which caused a problem of inability of measurement or not permitting high-accuracy measurement. Also, a semiconductor device to which the packaging structure as called as Lead On Chip is applied has such an arrangement that a lead frame covers the top surface of semiconductor chip. Thus, similarly to the case of the multilayer wiring, the lead frame will be a shielding object and interrupt the very weak light, resulting in inability of measurement or not permitting high-accuracy measurement.

Further, there is another problem in applications of the emission microscope. For example, it is known as an observing method that a top surface of a plastic mold is chemically removed, e.g., by fuming nitric acid to expose the surface of semiconductor chip and when a predetermined bias power source is connected to a lead frame to supply power to internal circuits of the semiconductor chip, very weak light is emitted from an anomalous portion, which is observed from the top surface of the semiconductor chip. However, when the plastic mold is chemically removed, e.g., by fuming nitric acid, the circuit patterns or others inside the semiconductor chip could be damaged, which could hinder observation of an anomalous portion to be observed originally.

To solve these problems of emission microscopes, a semiconductor device inspection system (Japanese Patent Application No. HEI 5-177957 (177957/1993) corresponding to European application EP-A-635883, filed 18th July 1994) was developed. This inspection system is to illuminate the back surface of a semiconductor device, that is, the back surface where shielding objects such as multilayer wiring of the semiconductor chip are not formed, by an infrared-ray epi-illumination means and to take an optical image reflected and transmitted through the semiconductor chip. Therefore, an observed image specifying an anomalous location in the semiconductor chip can be obtained. However, even with this semiconductor device inspection system, still there were problems to be solved, e.g., large noise components, in order to obtain a clearer image.

JP-A-61263235 and JP-A-63134943 describe semiconductor inspecting devices in which infrared imaging is used in the detection of defective portions in a semiconductor device. JP-A-1109735 describes a method of inspecting a wiring layer in which infrared light of a specific wavelength is applied to the rear of a substrate and light transmitted through the substrate is detected.

The invention aims to provide a semiconductor device inspection system capable of obtaining a clearer image.

According to the invention there is provided an inspection system for semiconductor devices, the system comprising: means for applying a voltage to a device under inspection; epi-illumination means comprising a source of radiation and a filter, said filter being operable to filter radiation from said source to generate a beam of radiation for which semiconductor material of said device under inspection is substantially transparent, said epi-illumination means being operable to illuminate a back side of said device with said beam of radiation; means for detecting radiation from said back side of said device to generate an image; means for left-to-right reversing said image generated by said detecting means; and means for superimposing an image generated by said radiation detection means in a first mode of system operation with an image generated by said radiation detection means in a second mode of system operation; wherein: in said first mode of system operation the device under inspection is illuminated by said epi-illumination means without the application of a voltage by said voltage application means and said detecting means generates an image of circuitry of said semiconductor device, and in said second mode of system operation a voltage is applied to said device under inspection by said voltage application means without illumination by said epi-illumination means to cause anomalies in said device to emit light, said detection means being operable to detect said emitted light and to generate an image of said anomalies.

Another aspect of the invention relates to a method having the steps defined in Claim 7.

An embodiment of the invention to be described comprises infrared-ray epi-illumination means, image pickup means, image reversing means, adding means, and superimposed display control means.

The infrared-ray epi-illumination means makes light in a wide wavelength region including an infrared region emitted from a light source pass through an optical filter made of the same material as that of the semiconductor device to form an infrared ray and irradiates the back surface of the semiconductor device with the infrared ray.

The image pickup means picks up an image reflected and transmitted inside the semiconductor device when the back surface of the semiconductor device is irradiated with the infrared ray, and further detects (picks up) very weak light generated inside the semiconductor device under no illumination.

The image reversing means produces first left-to-right-reversed image data by left-to-right-reversing an array of pixels in image data output when the image pickup means picks up the image of the bottom surface of the semiconductor device under illumination by the infrared-ray epi-illumination means and produces second left-to-right-reversed image data by left-to-right-reversing an array of pixels in image data output when the image pickup means picks up an image of very weak light emitted from an anomalous portion in the semiconductor device under no illumination.

The adding means superimposes the first left-to-right-reversed image data and the second left-to-right-reversed image data generated by the image reversing means with correspondence of pixel array and outputs superimposed data.

The superimposed display control means makes display means display a restored image, based on the superimposed data output from the adding means.

In the infrared ray semiconductor device inspection system of the present invention having the above-described structure; an image of the semiconductor device to be measured is taken from the bottom and an image of very weak light from the anomalous occurring portion and a pattern image are taken and displayed as a superimposed observed image as if it is observed from the top. Therefore, even though there exists a shielding object such as aluminum wiring, which interrupts light, on the top surface, the anomalous occurring location can be specified with high accuracy. Further, the image of very weak light is converted into the image observed from the top in real time and displayed, so that anomalous occurrence can be analyzed for short period of time.

In particular, in the infrared-ray epi-irradiation means, an optical filter made of the same material as that of the semiconductor device to be measured is used to form infrared rays for illumination, so that light having a short wavelength which is easily reflected on the surface of the semiconductor device is interrupted and infrared rays having high transmittance against the semiconductor device can be obtained. In result, an image of reflected and transmitted infrared rays is picked up and an image of a noise component reflected at the surface of the semiconductor device is significantly suppressed. Therefore, a clear image which has less noise component and offset component can be obtained.

For example, to measure a semiconductor device made of silicon semiconductor, a silicon filter made of the same material as that of the semiconductor device is used as an optical filter. Then, the absorption wavelength limit of the silicon filter is a wavelength (about 1100nm) equivalent to the energy band gap (about 1.1ev) of silicon. Accordingly, light having a wavelength shorter than the absorption wavelength limit is removed and infrared rays having a wavelength longer than the absorption wavelength limit irradiate the semiconductor device. The wavelength region of the infrared ray matches with the transmittance sensitive region of the semiconductor device. Consequently, an image can be picked up with high sensitivity.

The above and further features of the invention are set forth with particularity in the appended claims and together with advantages thereof will become clearer from consideration of the following detailed description of an illustrative embodiment of the invention given with reference to the accompanying drawings.

In the drawings:
Fig. 1 is a block diagram showing the whole structure of one embodiment of a semiconductor device inspection system according to the present invention;
Fig. 2 is a block diagram showing the detailed structure of an image pickup optical system and an infrared-ray epi-irradiation device of one embodiment;
Fig. 3 is a block diagram showing the detailed structure of a cooled CCD camera and a control section of one embodiment;
Fig. 4 is a block diagram showing the detailed structure of an analysis section of one embodiment;
Fig. 5 is a view illustrating the structure of an image reversing unit in an analysis section and its function; and
Fig. 6 is a flowchart to explain the operation of one embodiment.

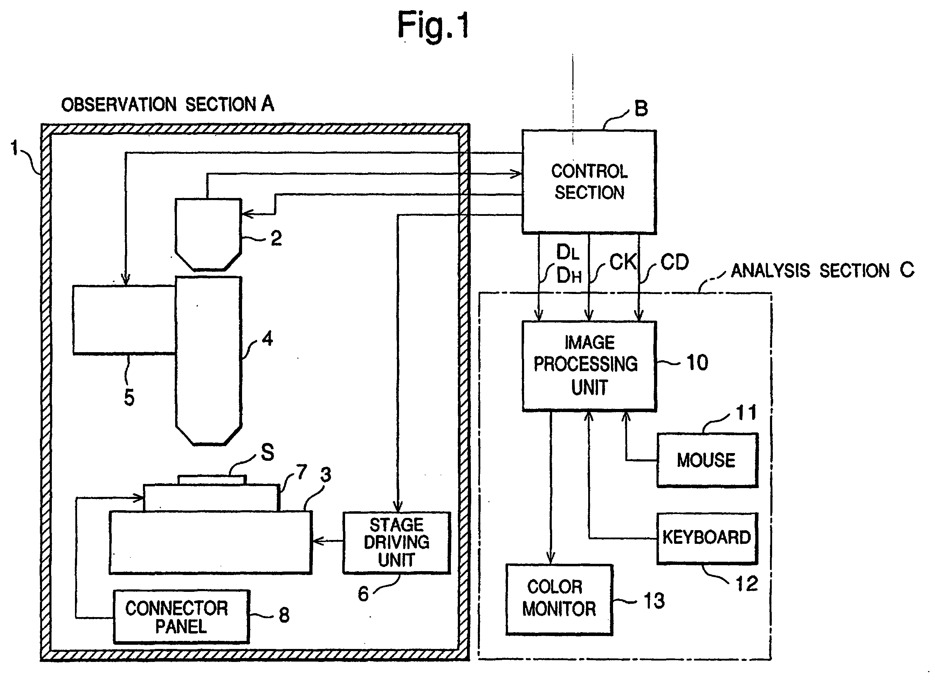

One embodiment of an infrared-ray semiconductor device inspection system according to the present invention will be explained with reference to the drawings. First, referring to Fig. 1, the whole structure of the embodiment will be explained. The semiconductor device inspection system comprises an observation section A including a dark room box 1, a control section B for controlling a cooled CCD camera 2 and other components installed in the dark room box, and an analysis section C for receiving an image signal output from the cooled CCD camera 2 through the control section B and performing predetermined image processing.

The dark room box 1 for intercepting incidence of external light contains:a motor-driven XYZ stage 3 for carrying a semiconductor device S to be measured thereon and moving it in the X,Y,Z coordinate directions to position the semiconductor device S; an image pickup optical system 4 provided opposing to the motor-driven XYZ stage 3, for magnifying an image from the semiconductor device S by an arbitrary magnification within a predetermined range; the cooled CCD camera 2,which is provided for taking an image passing through the image pickup optical system 4; an infrared-ray epi-illumination device 5 for irradiating the semiconductor device S with infrared rays through the image pickup optical system 4; a stage driving unit 6 for controlling operations of the motor-driven XYZ stage 3 by supplying power; a test fixture 7 for supplying power to the semiconductor device S to make it operate and supplying a control signal; and a connector panel 8 for commanding the test fixture 7 to supply a control signal or others.

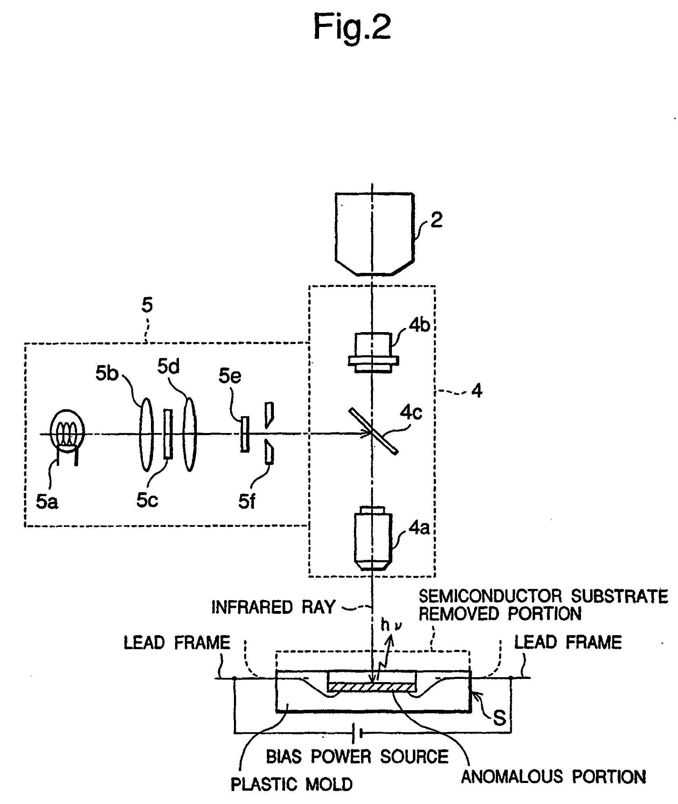

Next, referring to Fig. 2, the detailed structure of the image pickup optical system 4 and the infrared-ray epi-illumination device 5 will be described. The image pickup optical system 4 comprises an objective lens system 4a capable of magnifying an image from the semiconductor device S by an arbitrary magnification within a predetermined range, an image forming lens system 4b for forming an image magnified by the objective lens system 4a on a light receiving surface of the cooled CCD camera 2, and a half mirror 4c located between the objective lens system 4a and the image forming lens system 4b. Optical axes of the objective lens system 4a, the half mirror 4c and the image forming lens system 4b are matched with a normal of the light receiving surface of the cooled CCD camera 2. Note that the half mirror 4c transmits an image from the objective lens system 4a to the image forming lens system 4b and reflects infrared rays for illumination from the infrared-ray epi-illumination device 5 towards the objective lens system 4a.

The infrared-ray epi-illumination device 5 comprises a halogen lamp 5a which is a light source, and a condenser lens 5b, a transparent optical filter 5c, a condenser lens 5d, a diffusing plate 5e, and a field stop 5f, which are for forming infrared rays for illumination from light emitted from the halogen lamp 5a and emitting infrared rays to the half mirror 4c and which are placed along the same optical axis. In particular, light emitted from the halogen lamp 5a becomes parallel beams by the condenser lens 5b, and only infrared rays having a wavelength longer than a predetermined wavelength among parallel beams transmit through the optical filter 5c and the infrared rays are collected to a focal point by the condenser lens 5d. The diffusing plate 5e is placed at a focal point of the condenser lens 5d, and converts the collected infrared rays uniformly. Further, the field stop 5f reduces the uniform infrared rays into a predetermined beam, and emits it to the half mirror 4c.

In this embodiment, the optical filter 5c is a transparent optical filter made of the same material as that of the semiconductor device S to be measured since the semiconductor device S is made of silicon semiconductor.

Then, the infrared ray exited from the field stop 5f is reflected by the half mirror 4c, and transmits the objective lens 4a and then irradiates the semiconductor device S.

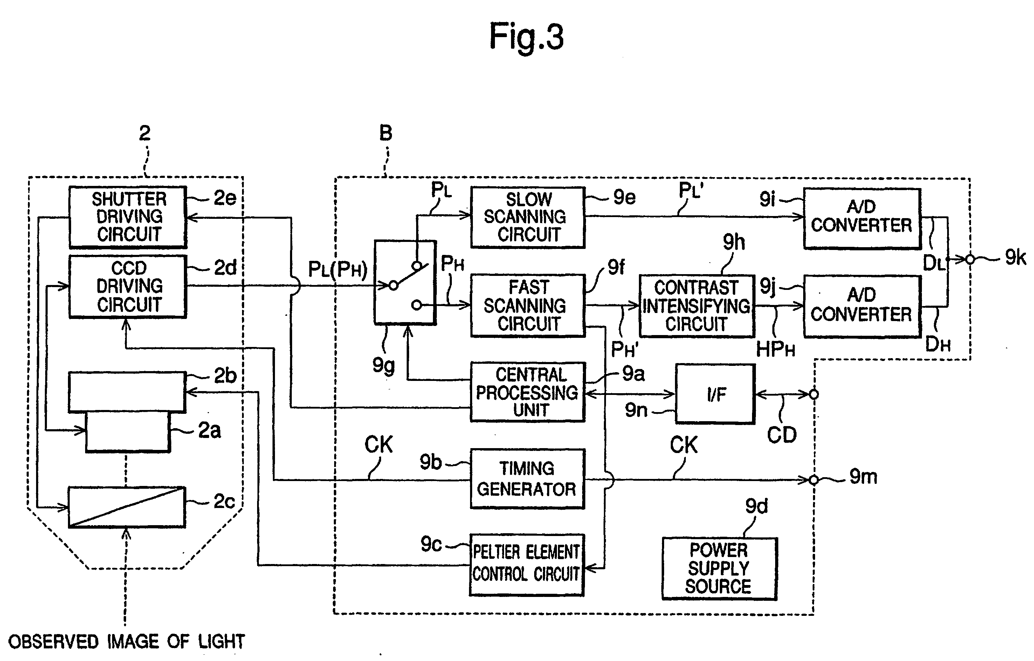

Next, referring to Fig. 3, the structure of the cooled CCD camera 2 and the control section B will be explained. First, the cooled CCD camera 2 comprises a CCD solid state image sensor 2a having 1000x1018 pixels and a Peltier element 2b fixed in the CCD solid state image sensor. The CCD solid state image sensor 2a and the Peltier element 2b are placed in vacuum atmosphere which is set in vacuum by a vacuum pump (not shown) all the time. A shutter device 2c is placed in front of the light receiving surface (matched with the surface on which the image is formed by the image forming lens system 4b) of the CCD solid state image sensor 2a. Then, a CCD driving circuit 2d controls image pickup operations of the CCD solid state image sensor 2a, synchronizing with a synchronizing signal CK supplied from a timing generator 9b in the control section B. Further, a shutter driving circuit 2e controls opening and closing operations of the shutter device 2c based on instruction from a central processing unit 9a having a microprocessor. Furthermore, the Peltier element 2b is driven by current supplied from a Peltier element control circuit 9c in the control section to cool the CCD solid state image sensor 2a at a fixed temperature all the time thereby to suppress dark current generation and noise generation due to heat in the whole cooled CCD camera 2. The cooled CCD camera 2 is able to switch a slow pickup mode in which images are picked up for a long period of time and a signal P_{L} for each pixel is read out from the CCD solid state image sensor 2a at point sequential timing of low frequency, and a fast pickup mode in which images are picked up for a short period of time as compared with the slow pickup mode and a signal P_{H} for each pixel is read out from the CCD solid state image sensor 2a at point sequential timing of high frequency. In the slow pickup mode, one frame cycle (cycle for reading out all image signals for pixels of one still image) is set to 4 seconds and in the fast pickup mode, it is set to 0.125 seconds.

The control section B comprises a central processing unit 9a for controlling whole operations of the observation section A and the control section B, a timing generator 9b for generating a synchronizing signal CK to set image pickup timing in the slow pickup mode and the fast pickup mode through the CCD driving circuit 2d, a Peltier element control circuit 9c for controlling temperature of the Peltier element 2b, and a power supply source 9d for supplying power required for whole operations of the observation section A and the control section B.

Further, the control section B comprises a slow scanning circuit 9e for holding and sampling an image signal P_{L} for each pixel, which is read out from the CCD solid state image sensor 2a at predetermined point sequential timing (reading timing for one pixel, hereinafter called slow point sequential timing) in the slow pickup mode in synchronization with the slow point sequential timing, a fast scanning circuit 9f for holding and sampling an image signal P_{H} for each pixel, which is read out from the CCD solid state image sensor 2a at predetermined point sequential timing (reading timing for one pixel, hereinafter called fast point sequential timing) in the fast pickup mode in synchronization with the fast point sequential timing, and a changeover circuit 9g for switching the image pickup modes to transmit the respective image signals P_{L} and P_{H} read out from the CCD solid state image sensor 2a to the slow scanning circuit 9e and the fast scanning circuit 9f.

Further, a contrast intensifying circuit 9h removes unnecessary signal components from the image signal P_{H}' output from the fast scanning circuit 9f in the fast pickup mode, and thereafter amplifies the signal by a predetermined gain to form an image signal HP_{H} with high contrast. In other words, the contrast intensifying circuit 9h removes a noise component and an offset component the amplitude of which are lower than threshold voltage V_{TH} from the signal P_{H}' output from the fast scanning circuit 9f, which leaves a real image signal P_{H}'. Thereafter, the contrast intensifying circuit 9h amplifies the signal P_{H}', and then outputs the image signal HP_{H} with high contrast. Note that the threshold voltage V_{TH} can be arbitrarily adjusted by an observer.

Next, an A/D converter 9i converts an analog image signal P_{L}' output from the slow scanning circuit 9e into digital image data D_{L} in the slow pickup mode. On the contrary, an A/D converter 9j converts an analog signal HP_{H} output from the contrast intensifying circuit 9h into digital image data D_{H} in the fast pickup mode. Then these image data D_{L} and D_{H} are transmitted to the analysis section C through a common output terminal 9k.

Since the sample hold timing of the slow scanning circuit 9e and the fast scanning circuit 9f synchronizes with a synchronizing signal CK from the timing generator 9b, the sample hold timing also synchronizes with the point sequential reading timing of the CCD solid state image sensor 2a in the slow pickup mode and the fast pickup mode. In order to assure transmittance of image data D_{L} and D_{H} to the analysis section C, the synchronizing signal CK is supplied to the analysis section C through the synchronizing signal output terminal 9m, and various kinds of control data CD are transmitted between the central processing unit 9a and the analysis section C through an interface circuit 9n which is in conformity with the RS232C standard.

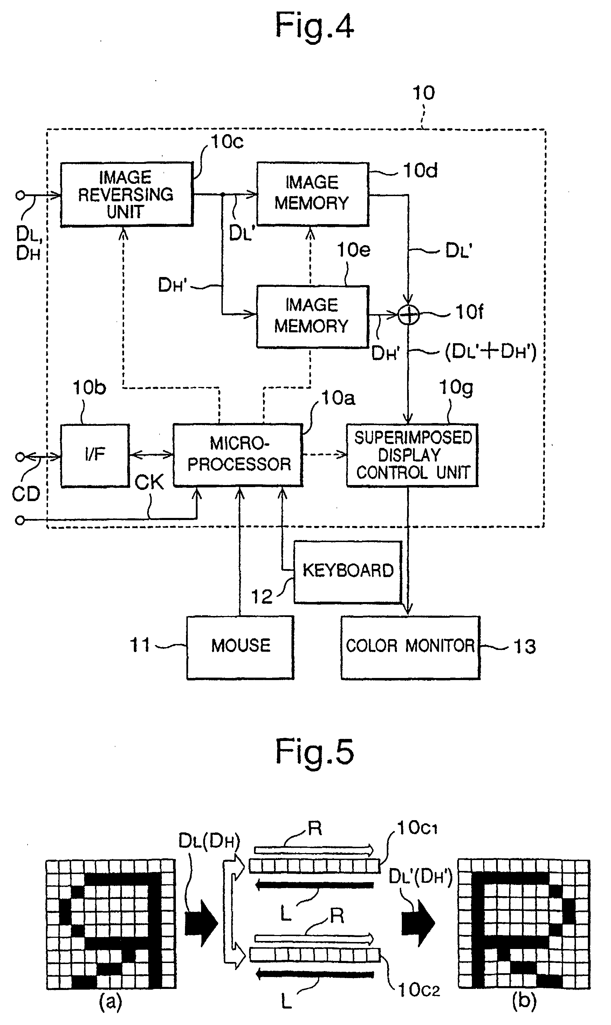

Next, referring to Fig. 1 and Fig. 4, the structure of the analysis section C will be explained. First, in Fig. 1, the analysis section C comprises an image processing unit 10 including a microprocessor 10a having various kinds of arithmetic functions, and a mouse input device 11, a keyboard input device 12 and a color monitor device 13 which are attached to the image processing unit 10. The image processing unit 10 receives image data D_{L} and D_{H} transmitted from the control unit 9 and receives and transmits various kinds of control data CD from and to the central processing unit 9a through an interface circuit 10b connected to an interface circuit 9n in the control section B in accordance with the RS232C standard. Further, the image processing unit 10 receives the synchronizing signal CK from the timing generator 9d.

The internal structure of the image processing unit 10 will be explained. The image processing unit 10 comprises an image reversing unit 10c for changing the arrangement of the image data D_{L} (or D_{H}) of a predetermined number of pixels transmitted from the control unit B to produce left-to-right-reversed image data D_{L}' (or D_{H}') for obtaining a left-to-right-reversed, reproduced image, an image memory 10d for storing left-to-right-reversed image data D_{L}' of one frame from the image reversing unit 10c in the slow pickup mode, an image memory 10e for storing left-to-right-reversed image data D_{H}' of one frame from the image reversing unit 10c in the fast pickup mode, an adding circuit 10f for adding the left-to-right-reversed image data D_{L}' and D_{H}' read out from the image memories 10d and 10e pixel by pixel to output the added image data (D_{L}'+D_{H}'), and an superimposed display control unit 10g for converting the added image data (D_{L}' + D_{H}') output from the-adding circuit 10f into video signal V_{D} of video rate for each pixel to supply it to the color monitor 13.

The image reversing unit 10c, as shown in Fig. 5, includes one pair of line buffers 10_{C1} and 10_{C2} for storing and outputting image data D_{L} (or D_{H}) transmitted from the control section B in one horizontal line basis (in this embodiment, 1018 pixels). The input timing of each image data D_{L} (or D_{H}) and the output timing of each left-to-right-reversed image data D_{L} (or D_{H}) synchronizes with the slow point sequential timing in the slow pickup mode, and synchronizes with fast point sequential timing in the fast pickup mode. In other words, the line buffers 10_{C1} and 10_{C2} operate synchronizing with the synchronizing signal CK to convert the arrangement of image data D_{L} into left-to-right-reversed image data D_{L}' synchronizing with slow sequential timing in the slow pickup mode, and to convert the arrangement of image data D_{H} into left-to-right-reversed image data D_{H}' synchronizing with fast sequential timing in the fast sequential timing. Further, the line buffers 10_{C1} and 10_{C2} input image data D_{L} (or D_{H}) by successively shifting data in a direction shown by the arrow R in Fig. 5 in synchronization with the point sequential reading timing and store image data D_{L} (or D_{H}) of one horizontal line when the line buffers input image data D_{L} (or D_{H}). Conversely, the line buffers 10_{C1} and 10_{C2} output the temporary stored image data D_{L} (or D_{H}) in the reverse order to that upon input by successively shifting data in a direction shown by the arrow L in Fig. 5 when the buffers output data. Accordingly, thus outputted image data D_{L}' (or D_{H}') are left-to-right-reversed image data, which are reversed left to right with respect to the pixel order in the image data D_{L} (or D_{H}).

Further, in synchronization with the above one horizontal reading cycle, one line buffer 10_{C1} is in input operation while the other line buffer 10_{C2} is in output operation. The operations of line buffers are switched by turns in synchronization with the above one horizontal reading cycle. Accordingly, while the line buffer 10_{C1} is in input operation to store image data D_{L} (or D_{H}) of one horizontal line, the other line buffer 10_{C2} outputs the image data D_{L} (or D_{H}) having been stored in the previous one horizontal reading cycle in the direction shown by the arrow L so as to output the left-to-right-reversed image data D_{L}' (or D_{H}') to the image memory 10d (or 10e). Conversely, while the line buffer 10_{C2} is in input operation to store image data D_{L} (or D_{H}) of one horizontal line, the other line buffer 10_{C1} outputs the image data D_{L} (or D_{H}) having been stored in the previous one horizontal reading cycle in the direction shown by the arrow L so as to output the left-to-right-reversed image data D_{L}' (or D_{R}') to the image memory 10d (or 10e). Such left-to-right-reversing process is repeated as the operations are switched every one horizontal reading cycle, so that, for example, the image data D_{L} (or D_{H}) as shown in (a) of Fig. 5 are converted into the left-to-right-reversed image data D_{L}' (or D_{R}') as shown in (b) of Fig. 5. Then, such left-to-right-reversing process is carried out in real time in synchronization with the one horizontal reading cycle of the CCD solid state image sensor 2a and the timing of point sequential scan reading in the pixel-by-pixel basis.

Further, the mouse input device 11 and the keyboard input device 12 function as input devices when an operator gives an instruction to start measurement, adjusts the threshold voltage V_{TH}, and controls the operations of another systems.

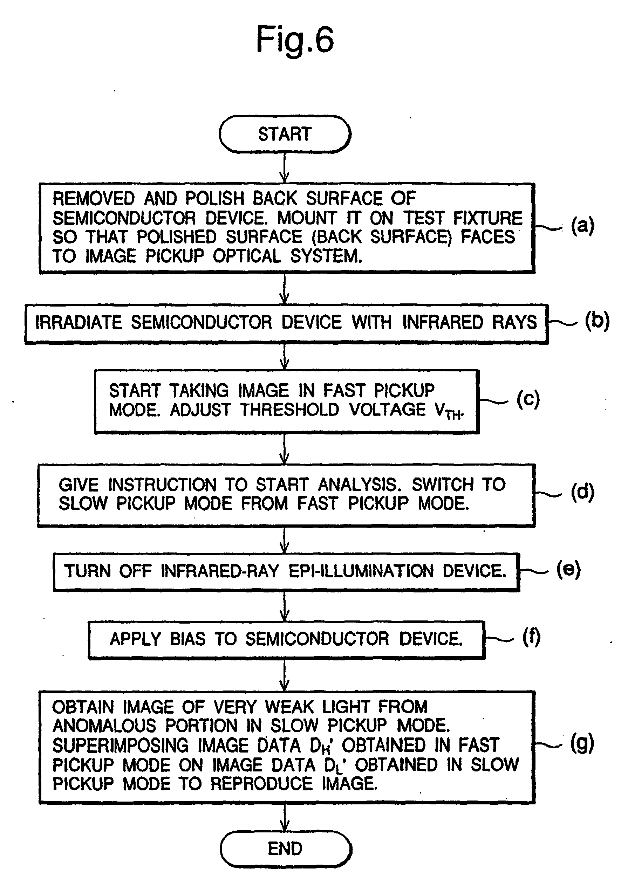

Next, the operation of the semiconductor inspection system having such structure will be described, referring to the flowchart shown in Fig. 6.

First, in Step (a) of Fig. 6, a measuring person removes the bottom portion of mold package of semiconductor device S and polishes to obtain a mirror-finished surface of substrate of semiconductor chip and sets the semiconductor device S on the test fixture 7 such that the back surface is opposed to the objective lens system 4a.

Next, in Step (b), the measuring person manipulates the mouse input device 11 or the keyboard input device 12 to illuminate the semiconductor device S by the infrared-ray epi-illumination device 5.

Then in Step (c), as the cooled CCD camera 2 is set to the fast pickup mode, the central processing unit 9a sets one frame cycle to 0.125 seconds and gives a predetermined period within the one frame cycle to the shutter driving circuit 2e as the exposure period. Next, the shutter device 2c repeats opening and closing for exposure and the CCD solid state image sensor 2a repeats taking image until the fast pickup mode is terminated, which will be described later. Accordingly, the color monitor 13 displays still picture every 0.125 seconds successively.

The image taking operation in one frame cycle will be described. As shown in Fig. 2, an infrared ray irradiating the back surface of semiconductor device S passes through the semiconductor substrate of semiconductor chip and light reflected on the surface of the semiconductor chip is incident on the image pickup optical system 4. Then during a predetermined exposure period, the shutter device 2c remains open, so that the cooled CCD camera 2 takes a reflected image. That is, the cooled CCD camera 2 takes an image, e.g., of circuit patterns formed on the front surface of semiconductor chip from the back surface. After the predetermined exposure period elapses, the CCD solid state image sensor 2a outputs each image signal P_{H}, synchronizing with the fast point sequential timing. The fast scanning circuit 9f samples each image signal P_{H} through the changeover circuit 9g, and the contrast intensifying circuit 9h removes a noise component and an offset components from the image signal P_{H}. Further, the A/D converter 9j converts the image signal P_{H} into digital image data D_{H}.

Here, one significant point is that when the semiconductor device S in which the substrate (chip) is made of silicon semiconductor is observed, the transparent optical filter 5c is a silicon filter made of the same material as that of the semiconductor device S, which makes the high sensitive image taking possible. In particular, because absorption wavelength limit of the silicon filter 5c is a wavelength (about 1100nm) equivalent to energy band gap (about 1.1eV) of silicon, light having a wavelength shorter than the absorption wavelength limit is removed and infrared rays having a wavelength longer than the absorption wavelength limit are used for illumination. On the other hand, energy band gap of silicon semiconductor substrate of semiconductor device S is also about 1.1eV. Accordingly, the silicon semiconductor substrate is superior in transmittance of infrared rays having a wavelength longer than about 1100nm. Infrared rays for illumination generated by means of silicon filter 5c have spectra of long wavelength which exactly match with a transmittance property of the silicon semiconductor, so that an image can be picked up with high sensitivity. Infrared rays for illumination have optimum transmittance to the silicon semiconductor after light having a wavelength shorter than,a wavelength of about 1100nm is removed, which lowers light to be reflected at the polished surface (back surface) of substrate. Then, almost all of images of reflected light are due to light transmitted and reflected inside the substrate of the semiconductor chip. Therefore, an image of reflected light has a very few noise component and offset component, and circuit patterns formed in the semiconductor chip can be picked up clearly from the back surface.

Thus obtained image data D_{H} are converted into left-to-right-reversed image data D_{H}' in which the arrangement is reversed left to right by the image reversing unit 10c and temporary stored in the image memory 10e. Further, the left-to-right-reversed image data D_{H}' is read out from the image memory 10e in real time and displayed on the color monitor 13 through the adding circuit 10f and the superimposed display control unit 10g. Since the image data D_{H} applied to the image reversing unit 10c are data of circuit pattern image or others as seen from the bottom of the semiconductor chip of the semiconductor device S, the left-to-right-reversed image data D_{H}' are data of circuit pattern image (ordinary surface pattern image) as seen from the top of the semiconductor chip of the semiconductor device S and the reproduced image displayed on the color monitor 13 is still picture of ordinary top surface pattern.

Then, the measuring person moves the motor-driven XYZ stage 3 in XY directions while watching the picture (displayed frame by frame) successively displayed on the color monitor 13 to specify the portion of the semiconductor device S to be observed. Further, the measuring person can focus the image by adjusting the height of the motor-driven XYZ stage 3 in Z direction. Furthermore, a clear image from which a noise component and an offset component are removed can be obtained by adjusting the threshold voltage V_{TH} of the contrast intensifying circuit 9h.

Next, in Step (d) of Fig. 6, when the measuring person gives an instruction to start anomalous analysis, the system holds the left-to-right-reversed image data D_{H}' of one frame stored in the image memory 10e immediately before the instruction, and terminates the fast pickup mode and concurrently switches to the slow pickup mode. In the slow pickup mode, the central processing unit 9a turns off the halogen lamp 5a to terminate the illumination of the infrared-ray epi-illumination device 5 (Step (e)) and then the test fixture 7 starts applying an operating voltage to the semiconductor device S and applying a predetermined signal such as an operation timing clock (step (f)). Further, the central processing unit 9a sets one frame cycle to 4 seconds and gives a predetermined period within one frame cycle to the shutter driving circuit 2e as an exposure period. Note that the exposure period in the slow pickup mode is longer than that in the fast pickup mode, and cycle of slow point sequential timing is longer than that cf fast point sequential timing. That is, the image signal generated in each pixel of the CCD solid state image sensor 2a is read out at slow speed compared with the fast image pickup mode.

Next, in Step (g), the CCD solid image sensor 2a starts taking an image in the slow pickup mode. Then, the shutter device 2c repeats opening and closing for exposure and the CCD solid state image sensor 2a repeats taking image until the slow pickup mode is terminated. Accordingly, the color monitor 13 successively displays still picture every 4 seconds.

The image taking operation in one frame cycle will be described. If there exists some anomaly-occurring portion on the semiconductor chip of the semiconductor device S, the portion will emit very weak light, which will be picked up as an image thereof by the CCD solid state image sensor 2a. Further, since exposure is made for a long period in the slow pickup mode, a clear image of very weak light is obtained. Then after the predetermined exposure time elapses, the CCD solid state image sensor 2a outputs the image signal P_{L}, synchronizing with the slow point sequential timing, and the slow scanning circuit 9e samples the image signal P_{L} through the changeover circuit 9g, and the A/D converter 9i converts the image signal P_{L} into digital image data D_{L}.

Here, one significant point is that since the slow scanning circuit 9e samples and holds every image signal P_{L} at slow speed in synchronization with the slow point sequential timing, noise of high frequency due to switching when the image is sampled and held can be significantly suppressed and the image signal P_{L}' with high S/N can be obtained.

Next, thus obtained image data D_{L} are converted into the left-to-right-reversed image data D_{L}' in which the arrangement is reversed left to right with respect to the pixel by the image reversing unit 10c, and stored in the image memory 10d. Note that as shown in Fig. 5, the left-to-right-reversed image data D_{L}' are equivalent to data as seen from the top of the semiconductor chip of the semiconductor device S.

Further, the image memory 10e stores the left-to-right-reversed image data D_{L}' and at the same time, outputs the left-to-right-reversed image data D_{L}'. The image memory 10d also outputs the left-to-right-reversed image data D_{H}' with respect to the pixel of the left-to-right-reversed image data D_{L}'. The left-to-right-reversed image data D_{L}' and the left-to-right-reversed image data D_{H}' corresponding to each pixel are concurrently supplied to the adding circuit 10f in synchronization with the slow point sequential timing. The adding circuit 10f outputs the superimposed image data (D_{L}' + D_{H}'), and the superimposed display control unit 10g forms a video signal based on the superimposed image data (D_{L}' + D_{H}'). In result, the still picture of the image of very weak light showing the anomalous location superimposed on the circuit pattern of the semiconductor device S is displayed on the color monitor 13, and the still picture is switched every four seconds.

Then, when the measuring person gives an instruction to terminate anomalous analysis, the system holds the left-to-right-reversed image data D_{L}' and the left-to-right-reversed image data D_{H}', of one frame picture stored in the image memory 10d and the image memory 10e immediately before the instruction, respectively. The still picture of the left-to-right-reversed image data D_{L}' and the left-to-right-reversed image data D_{H}' are continuously displayed on the color monitor 13.

As described above, according to the embodiment, the measuring person can observe the anomalous portion easily while watching the display on the color monitor 13.

It should be noted that in the above embodiment, in order to measure the semiconductor device made of silicon semiconductor, the silicon filter is used as an optical filter 5c in the above embodiment, but the present invention is not limited to this. The present invention includes all cases of the optical filter 5c made of the same material as that of the semiconductor device to be measured.

Further, in the embodiment, the cooled CCD camera is used as image pickup means but the present invention is not limited to this. Other kinds of image pickup means can be used. In other words, image pickup means can be an image sensor having sensitivity to the wavelength region including the wavelength region of infrared rays generated using an optical filter made of the same material as that of the semiconductor device to be measured.

Further, in this embodiment, the silicon filter is used as an optical filter in order to measure the image of silicon semiconductor device, but the present invention includes all cases of the optical filter made of the same material as that of the device to be measured. For example, when the image of a GaAs semiconductor device is measured, the optical filter is made of GaAs material.

Thus, according to the described embodiment, an image of the semiconductor device to be measured is taken from the bottom and an image of very weak light from the anomalous occurring portion and a pattern image are taken and displayed as a superimposed observed image as if it is observed from the top. Therefore, even though there exists a shielding object such as aluminum wiring, which interrupts light, on the top surface, the anomalous occurring location can be specified. Further, the image of very weak light is converted into the image observed from the top in real time and displayed, so that anomalous occurrence can be analyzed for short period of time. Furthermore, an optical filter made of the same material as that of the semiconductor device to be measured is used to form infrared rays for illumination, so that infrared rays having high transmittance against the semiconductor device can be obtained. As a result of interrupting light having a short wavelength which is easily reflected on the surface of the semiconductor device, a clear reflected optical image which has less noise component and offset component can be taken.

Furthermore, the semiconductor inspection system which can analyze the anomalous occurrence of the semiconductor device at high speed and which is superior in operation and in measurement accuracy, can be provided.

From the embodiment thus described, it will be obvious that the invention may be varied in many ways without falling outside the scope of the invention, as defined by the following claims.

## Claims

1. An inspection system (A, B, C) for semiconductor devices (S), the system comprising:
means for applying a voltage to a device under inspection;
epi-illumination means (4, 5) comprising a source of radiation (5a) and a filter (5c), said filter (5c) being operable to filter radiation from said source (5a) to generate a beam of radiation for which semiconductor material of said device under inspection is substantially transparent, said epi-illumination means being operable to illuminate a back side of said device (S) with said beam of radiation;
means (2) for detecting radiation from said back side of said device (S) to generate an image;
means (10c) for left-to-right reversing said image generated by said detecting means (2); and
means (10f) for superimposing an image generated by said radiation detection means (2) in a first mode of system operation with an image generated by said radiation detection means (2) in a second mode of system operation;
wherein:
in said first mode of system operation the device under inspection (S) is illuminated by said epi-illumination means (4, 5) without the application of a voltage by said voltage application means and said detecting means (2) generates an image of circuitry of said semiconductor device (S), and
in said second mode of system operation a voltage is applied to said device under inspection (S) by said voltage application means without illumination by said epi-illumination means (4, 5) to cause anomalies in said device (S) to emit light, said detection means (2) being operable to detect said emitted light and to generate an image of said anomalies.

2. A system according to Claim 1, wherein said filter (5c) is of the same material as said device under inspection (S).

3. A system according to Claim 1 or 2, wherein said filter (2c) is of silicon or gallium arsenide (GaAs).

4. A system according to any preceding claim, wherein the filter (5c) is operable to generate a beam of infrared radiation for illumination of the device under inspection (S).

5. A system according to any preceding claim, comprising a stage (7) for supporting said device under inspection (S).

6. A system according to claim 5, comprising a dark room box (1) containing the stage (7), the light source (5a), the filter (5c), and the radiation detecting means (2).

7. A method of semiconductor device inspection, the method comprising the steps of:
(a) filtering radiation from a radiation source (5a) of epi-illumination means (2) to generate a beam of radiation for which semiconductor material of a device under inspection (S) is substantially transparent;
(b) epi-illuminating a back side of said device under inspection (S) with said radiation beam;
(c) detecting radiation from said back side of said device (S) to generate a first image of circuitry in said device under inspection (S);
(d) ceasing illumination of said device with said epi-illumination means (2);
(e) applying a voltage to said device under inspection (S);
(f) detecting light emitted by anomalies in said device under inspection (S) on application of said voltage to generate a second image of said anomalies;
(g) left-to-right reversing said first and said second images; and
(h) superimposing said first and second left-to-right reversed images.

## Patentansprüche

1. Untersuchungssystem (A, B, C) für Halbbauelemente (S) mit:
einer Vorrichtung zum Anlegen einer Spannung an ein zu untersuchendes Bauelement;
einer Epi-Illuminiervorrichtung (4, 5) mit einer Strahlungsquelle (5a) und einem Filter (5c), wobei das Filter (5c) dazu ausgelegt ist, eine Strahlung von der Quelle (5a) zu filtern, um einen Strahlungsstrahl zu erzeugen, für den das Halbleitermaterial des zu untersuchenden Bauelements im wesentlichen transparent ist, wobei die Epi-Illuminiervorrichtung dazu ausgelegt ist, die Rückseite des Bauelements (S) mit dem Strahlungsstrahl zu illuminieren;
einer Vorrichtung (2) zum Detektieren von Strahlung von der Rückseite des Bauelements (S) zum Erzeugen eines Bildes;
einer Vorrichtung (10c) zum Links-Rechts-Vertauschen des durch die Detektiervorrichtung (2) erzeugten Bildes; und
einer Vorrichtung (10f) zum Überlagern eines von der Strahlungsdetektionsvorrichtung (2) in einem ersten Systembetriebszustand erzeugten Bildes mit einem von der Strahlungdetektionsvorrichtung (2) in einem zweiten Systembetriebszustand erzeugten Bild;
wobei:
in dem ersten Systembetriebszustand das zu untersuchende Bauelement (S) durch die Epi-Illuminiervorrichtung (4, 5) ohne Anlegung einer Spannung durch die Spannungsanlegevorrichtung illuminiert wird, und die Detektionsvorrichtung (2) ein Schaltkreisbild des Halbleiterbauelements (S) erzeugt, und
in dem zweiten Systembetriebszustand ohne Illuminierung durch die Epi-Illuminiervorrichtung (4, 5) eine Spannung an das zu untersuchende Bauelement (S) durch die Spannungsanlegevorrichtung angelegt wird, damit Anomalien in dem Bauelement (S) dazu veranlasst werden, Licht zu emittieren, wobei die Detektionsvorrichtung (2) dazu ausgelegt ist, das emittierte Licht zu detektieren und ein Bild der Anomalien zu erzeugen.

2. System nach Anspruch 1, wobei das Filter (5c) aus dem gleichen Material ist wie das zu untersuchende Bauelement (S).

3. System nach Anspruch 1 oder 2, wobei das Filter (2c) aus Silizium oder Galliumarsenid (GaAs) ist.

4. System nach einem der vorhergehenden Ansprüche, wobei das Filter (5c) dazu ausgelegt ist, einen Strahl infraroter Strahlung zum Illuminieren des zu untersuchenden Bauelements (S) zu erzeugen.

5. System nach einem der vorhergehenden Ansprüche, mit einer Probenbühne (7) zum Tragen des zu untersuchenden Bauelements (S).

6. System nach Anspruch 5, mit einer Dunkelkammerbox (1) mit der Probenbühne (7), der Lichtquelle (5a), dem Filter (5c) und der Strahlungsdetektionsvorrichtung (2).

7. Verfahren zum Untersuchen eines Halbleiterbauelements, folgende Schritte umfassend:
(a) Filtern von Strahlung einer Strahlungsquelle (5a) durch eine Epi-Illuminiervorrichtung (2), um einen Strahlungsstrahl zu erzeugen, für den das Halbleitermaterial eines zu untersuchenden Bauelements (S) im wesentlichen transparent ist;
(b) Epi-Illuminieren einer Rückseite des zu untersuchenden Bauelements (S) mit dem Strahlungsstrahl;
(c) Detektieren von Strahlung von der Rückseite des Bauelements (S), um ein erstes Bild der Schaltkreise in dem zu untersuchenden Bauelement (S) zu erzeugen;
(d) Beenden des Illuminierens des Bauelements mit der Epi-Illuminiervorrichtung (2);
(e) Anlegen einer Spannung an das zu untersuchende Bauelement (S);
(f) Detektieren von licht, das durch Anomalien des zu untersuchenden Bauelements (S) bei Anlegen einer Spannung emittiert wird, um ein zweites Bild der Anomalien zu erzeugen;
(g) Links-Rechts-Vertauschen des ersten und des zweiten Bildes; und
(h) Überlagern des ersten und des zweiten linksrechts-vertauschten Bildes.

## Revendications

1. Système d'inspection (A, B, C) de dispositifs à semi-conducteurs (S), lequel système comprend :
- un moyen permettant d'appliquer une tension au dispositif inspecté ;
- un moyen d'illumination verticale (4, 5) comprenant une source de rayonnement (5a) et un filtre (5c), lequel filtre (5c) permet de filtrer le rayonnement provenant de la source (5a) afin de générer un faisceau de rayonnement pour lequel le matériau semi-conducteur dudit dispositif inspecté est transparent, ledit moyen d'illumination verticale pouvant illuminer le côté arrière dudit dispositif (S) à l'aide dudit faisceau de rayonnement ;
- un moyen (2) permettant de détecter le rayonnement depuis le côté arrière du dispositif (S) afin de générer une image ;
- un moyen (10c) permettant d'inverser de la gauche vers la droite l'image générée par ledit moyen de détection (2) ; et
- un moyen (10f) permettant de superposer l'image générée par ledit moyen de détection de rayonnement (2) lors d'un premier mode de fonctionnement à une image générée par ledit moyen de détection de rayonnement (2) lors d'un second mode de fonctionnement ;
dans lequel
- lors dudit premier mode de fonctionnement, le dispositif inspecté (S) est illuminé par ledit moyen d'illumination verticale (4, 5) sans que le moyen d'application de tension applique une tension, tandis que ledit moyen de détection (2) génère une image des circuits dudit dispositif à semi-conducteur (S) ; et
- lors dudit deuxième mode de fonctionnement, une tension est appliquée au dit dispositif inspecté (S) par ledit moyen d'application de tension sans illumination par ledit moyen d'illumination verticale (4, 5) de sorte que les anomalies dudit dispositif (S) émettent de la lumière, lequel moyen de détection (2) permet de détecter ladite lumière émise et de générer une image desdites anomalies.

2. Système, selon la revendication 1, dans lequel ledit filtre (5c) est fait du même matériau que le dispositif inspecté (S).

3. Système, selon la revendication 1, dans lequel ledit filtre (2c) est fait de silicium ou d'arseniure de gallium (GaAs).

4. Système, selon l'une quelconque des revendications précédentes, dans lequel le filtre (5c) permet de générer un faisceau de rayonnement infrarouge pour illuminer le dispositif inspecté (S).

5. Système, selon l'une quelconque des revendications précédentes, comprenant un étage (7) de support dudit dispositif inspecté (S).

6. Système, selon la revendication 5, comprenant une boîte de type chambre noire (1) contenant l'étage (7), la source de lumière (5a), le filtre (5c) ainsi que le moyen de détection de rayonnement (2).

7. Procédé d'inspection de dispositif à semi-conducteur, lequel procédé comprend les étapes suivantes :
(a) filtrer un rayonnement provenant de la source de rayonnement (5a) d'un dispositif d'illumination verticale (2) afin de générer un faisceau de rayonnement pour lequel le matériau semi-conducteur du dispositif inspecté (S) est essentiellement transparent ;
(b) illuminer verticalement le côté arrière dudit dispositif inspecté (S) à l'aide dudit faisceau de rayonnement ;
(c) détecter le rayonnement provenant dudit côté arrière dudit dispositif (S) afin de générer une première image des circuits dudit dispositif inspecté (S) ;
(d) interrompre l'illumination dudit dispositif par ledit moyen d'illumination verticale (2) ;
(e) appliquer une tension au dit dispositif inspecté (S) ;
(f) détecter la lumière émise par les anomalies dudit dispositif inspecté (S) lors de l'application de ladite tension afin de générer une seconde image desdites anomalies ;
(g) inverser de la gauche vers la droite lesdites première et seconde images ; et
(h) superposer ladite première image et ladite seconde image inversée de la gauche vers la droite.
